# EUROPÄISCHE PATENTSCHRIFT

(11) **EP 3 022 614 B1**
(45) Veröffentlichungstag und Bekanntmachung des Hinweises auf die Patenterteilung: **17.02.2021**
(21) Anmeldenummer: 14735895.6
(22) Anmeldetag: 27.06.2014
(51) Int. Cl.: G05B 19/409, B65C 9/40, B67C 3/00

(54) **BEHÄLTERBEHANDLUNGSMASCHINE MIT DISPLAY**
CONTAINER HANDLING MACHINE WITH DISPLAY
MACHINE DE TRAITEMENT DE CONTENANTS POURVUE D'UN AFFICHAGE

(30) Priorität: 17.07.2013 DE 102013214052
(43) Veröffentlichungstag der Anmeldung: 25.05.2016
(73) Patentinhaber: Krones AG, 93073 Neutraubling (DE)
(72) Erfinder: BERGERS, Andreas, 93073 Neutraubling (DE); ZÖLFL, Markus, 93073 Neutraubling (DE); PRONOLD, Timo, 93073 Neutraubling (DE); HAHN, Wolfgang, 93073 Neutraubling (DE)
(74) Vertreter: Grünecker Patent- und Rechtsanwälte PartG mbB
(86) Internationale Anmeldenummer: PCT/EP2014/063662
(87) Internationale Veröffentlichungsnummer: WO 2015/007499

(56) Entgegenhaltungen:
- EP-A2- 2 520 993
- DE-A1- 10 325 894
- DE-A1-102004 048 037
- DE-A1-102005 041 531
- DE-B3-102005 038 718
- DE-T2-602005 000 070
- US-A1- 2009 065 578

## Beschreibung

Die Erfindung betrifft eine Behälterbehandlungsmaschine mit im Maschinenschutz integrierten Display zur Anzeige von Informationen wie beispielsweise den Betriebszustand der Behälterbehandlungsmaschine.

### Stand der Technik

Aus dem Stand der Technik sind Behälterbehandlungsmaschinen, wie beispielsweise Etikettiermaschinen oder Blasformmaschinen hinlänglich bekannt. Aus der EP 23 06 254 A1 ist weiterhin bekannt, dass eine Behälterbehandlungsmaschine mit einer mobilen Anzeigevorrichtung versehen werden kann, die zur Ausgabe von Informationen an den Benutzer geeignet ist.

Der Benutzer kann diese Anzeigeeinheit aufgrund ihrer tragbaren Ausführung mit sich führen. Weiterhin lehrt diese Schrift, dass die Anzeigeeinheit in vorteilhafter Weise über Magneten an Teilen der Maschine angebracht werden kann, um dem Benutzer mehr Bewegungsspielraum beispielsweise bei Reparaturen einzuräumen.

Die DE 10055025 A1 lehrt weiterhin das Vorsehen von Anzeige- und Eingabeeinrichtungen, die Spinnereivorbereitungsmaschinen zugeordnet sind. Diese sind gemäß dieser Druckschrift als relativ einfache und kostengünstige Terminals vorgesehen.

Das Dokument DE 10 2005 038718 B3 betrifft eine Verpackungsmaschine zur Verarbeitung von Produkten und zur Aufnahme der Produkten in Folien, wobei die Verpackungsmaschine Schutztüren aufweist, in denen Fenster mit mindestens einer Glasscheibe angeordnet sind, auf der als Bildschirm jeweils ein Flach-Display angeordnet ist, das bevorzugt als Touchscreen ausgebildet ist. Auf dem Bildschirm werden der Ist-Zustand und/oder der Sollzustand der Arbeitsabläufe der Verpackungsmaschine und/oder der Produkte dargestellt.

Das Dokument EP 2 520 993 A2 offenbart eine Mensch-Maschine-Schnittstelle mit Anwendung bei Produktionsmaschinen, die den Ansatz einer dynamischen Ausgabe der Anzeige auf einem Display offenbart und zwar in Abhängigkeit von der Pupillenposition bzw. Blickrichtung des Benutzers, die über Kamera und Bildverarbeitung erfasst werden.

### Aufgabe

Ausgehend vom Stand der Technik besteht die zu lösende technische Aufgabe darin, die Interaktionsmöglichkeiten eines Bedieners einer Behälterbehandlungsmaschine zu verbessern und die Interaktionen mit der Behälterbehandlungsmaschine zu erleichtern.

### Lösung

Diese Aufgabe wird erfindungsgemäß durch die Behälterbehandlungsmaschine nach Anspruch 1 und das Verfahren zum Anzeigen von Informationen, wie dem Betriebszustand einer Behälterbehandlungsmaschine, nach Anspruch 9 gelöst. Zweckmäßige Ausgestaltungen der Erfindung sind in den Unteransprüchen erfasst.

Die erfindungsgemäße Behälterbehandlungsmaschine zur Behandlung von Behältern wie beispielsweise Flaschen, weist einen Maschinenschutz auf, der zumindest im Betrieb aktive Teile der Behälterbehandlungsmaschine gegen Eingriffe von außen, beispielsweise durch Bedienpersonal, abschirmt und sich zumindest teilweise über einen Teil der Peripherie der Behälterbehandlungsmaschine erstreckt, wobei in den Maschinenschutz ein Display integriert ist, auf dem Informationen z.B. über den Betriebszustand der Behälterbehandlungsmaschine angezeigt werden können. Durch dieses am Maschinenschutz vorgesehene Display wird ein für einen Bediener besonders einfaches Anzeigen von Informationen, die beispielsweise den Betriebszustand der Behälterbehandlungsmaschine betreffen, ermöglicht und gleichzeitig eine interaktive Schnittstelle zur Interaktion des Bedieners mit der Behälterbehandlungsmaschine geschaffen.

Eine Ausführungsform ist dadurch gekennzeichnet, dass das Display ein flexibles Display, beispielsweise ein OLED-Display ist. Da der Maschinenschutz in vielen Fällen keine ebene Oberfläche aufweist sondern eher einer Mantelfläche eines Zylinders entspricht, ist die Verwendung von OLED-Displays oder allgemein flexiblen Displays hier besonders geeignet, da sie auch über die Krümmung des Maschinenschutzes gelegt werden können und weiterhin die Möglichkeit besteht, diese Displays auch an aufklappbaren Teilen des Maschinenschutzes anzubringen, ohne dass es zu Beschädigungen kommt.

Gemäß der Erfindung ist eine Benutzererkennungseinheit vorgesehen, die geeignet ist, die Position eines Benutzers in der Umgebung der Behälterbehandlungsmaschine zu erkennen und eine Steuereinheit ist mit der Benutzererkennungseinheit und dem Display derart verbunden ist, dass die Anzeige auf dem Display in Abhängigkeit von der Position eines Benutzers ausgegeben werden kann. Eine so beispielsweise mit einem Bediener mitwandernde Anzeige kann Umrüstarbeiten, wie beispielsweise das Auswechseln einer Vielzahl von Formatteilen oder Einstellungen erheblich erleichtern, da der Bediener eine entsprechende Anleitung aus verschiedenen Positionen stets optimal eingesehen werden kann.

In einer Ausführungsform ist vorgesehen, dass die Benutzererkennungseinheit eine Kamera umfasst und die Steuereinheit über ein Bilderkennungsmodul verfügt. So kann mit Hilfe gängiger Bilderkennungssoftware und einer entsprechenden Kamera die Benutzererkennung realisiert werden.

Ferner kann vorgesehen sein, dass die Steuereinheit einen zugeordneten Speicher umfasst, in dem voreingestellte Anzeigeprofile gespeichert werden können und die Benutzererkennungseinheit weiterhin geeignet ist, einen Benutzer in der Umgebung der Behälterbehandlungsmaschine zu identifizieren und die Steuereinheit geeignet ist, eine Anzeige auf dem Display in Abhängigkeit der Identifikation des Benutzers und gespeicherter Anzeigeprofile auszugeben. Auf diese Weise kann eine individualisierte Anzeige von Informationen, die beispielsweise dem Betriebszustand der Behälterbehandlungsmaschine betreffen, realisiert werden. So kann beispielsweise eine Anleitung zur Umrüstung einer Maschine in mehreren Sprachen hinterlegt sein, die abhängig vom Benutzer, der die Umrüstung ausführt, in der für ihn am leichtesten verständlichen Sprache angezeigt wird.

Weiterhin kann sich das Display über einen Bereich des Maschinenschutzes erstrecken, der zumindest teilweise ein Behandlungsmodul zur Behandlung von Behältern umfasst. Das Ausbilden des Displays in unmittelbarer Nähe des Behälterbehandlungsmoduls erleichtert Arbeiten am Behälterbehandlungsmodul, da entsprechende Informationen, die dieses Behälterbehandlungsmodul betreffen, einem Bediener in unmittelbarer Nähe dazu angezeigt werden können.

Erfindungsgemäß ist das Display wenigstens teilweise als Touchdisplay ausgebildet.

Durch das Touchdisplay wird die Interaktion mit dem Display erheblich erleichtert.

Außerdem kann der Maschinenschutz zumindest teilweise aus Plexiglas bestehen und/oder sich das Display über mindestens 10%, vorzugsweise 20%, besonders bevorzugt 50% der Fläche des Maschinenschutzes erstrecken. Je nach vorgesehener Verwendung des Displays braucht sich dieses nicht über die gesamte Fläche des Maschinenschutzes zu erstrecken sondern es genügen auch Teile davon. So kann eine kostengünstige und gleichzeitig maximal effiziente Ausgestaltung des Displays realisiert werden.

In einer Ausführungsform ist die Behälterbehandlungsmaschine als Ausstattungsmaschine für Behälter, beispielsweise als Etikettiermaschine ausgebildet.

In einer Ausführungsform ist die Behälterbehandlungsmaschine als eine aus mehreren Einzelmaschinen bestehende Blockmaschine ausgebildet.

Unter Verwendung dieser Vorrichtung lässt sich ein Verfahren zum Anzeigen von Informationen, die beispielsweise den Betriebszustand einer Behälterbehandlungsmaschine angeben, verwirklichen, wobei die Informationen auf einem im Maschinenschutz der Behälterbehandlungsmaschine integrierten Display angezeigt werden. Über die Darstellung der Informationen auf diesem Display wird einem Benutzer die Bedienung der Behälterbehandlungsmaschine erleichtert.

Erfindungsgemäß wird mittels einer Benutzererkennungseinheit ein Benutzer in der Umgebung der Behälterbehandlungsmaschine erkannt und eine Anzeige auf dem Display über eine Steuereinheit in Abhängigkeit von der Position des Benutzers gesteuert. Eine vom Benutzer bzw. dessen Position abhängige Darstellung auf dem Display kann unnötige Arbeitswege während einer Umrüstung oder sonstiger Arbeiten an der Behälterbehandlungsmaschine (beispielsweise hin- und herlaufen zwischen einem zentralen Terminal und der Behälterbehandlungsmaschine) minimieren oder gar ganz überflüssig machen, wodurch die Arbeit eines Bedieners erheblich erleichtert wird.

Es kann vorgesehen sein, dass die Benutzererkennungseinheit den Benutzer identifiziert und die Anzeige auf dem Display in Abhängigkeit von der Identifikation des Benutzers und in Abhängigkeit von in einem Speichern gespeicherten Profilen durch die Steuereinheit gesteuert wird. Die Darstellung der Informationen auf dem Display in Abhängigkeit von entsprechenden Nutzerprofilen kann weiterhin dazu beitragen, den Umgang einer Bedienperson mit der Behälterbehandlungsmaschine effektiver zu gestalten.

In einer Ausführungsform ist das Verfahren dadurch gekennzeichnet, dass die Steuereinheit die Position und/oder Darstellungsform der Anzeige auf dem Display gemäß einer Veränderung der Position des Benutzers in Echtzeit ändert. Eine so mitlaufende Anzeige auf dem Display gestattet es dem Bediener zu jeder Zeit, die gewünschten Informationen passenderweise angezeigt zu bekommen.

Erfindungsgemäß wird die Anzeige auf dem Display durch Interaktion eines Benutzers über das als Touchdisplay ausgebildete Display verändert. Durch diese Ausgestaltung wird die Interaktion mit dem Display erleichtert. Dabei kann die Ausgestaltung als Touchdisplay eine große Mannigfaltigkeit an Interaktionsmöglichkeiten eines Bedieners mit der Behälterbehandlungsmaschine bereitstellen, wohingegen ein mobiles Endgerät weiterhin den Vorteil aufweist, dass ein Bediener auch von einer Position aus, in der er das Display zwar einsehen aber nicht bedienen kann, mit diesem interagieren kann.

### Kurze Beschreibung der Figuren

- Fig. 1a und 1b: Schematische Darstellung einer erfindungsgemäßen Behälterbehandlungsmaschine.
- Fig. 2a und 2b: Schematische Darstellung verschiedener Ausführungsformen des Maschinenschutzes.
- Fig. 3: Schematische Darstellung einer Vorrichtung zur Benutzererkennung.
- Fig. 4a und 4b: Schematische Darstellung einer Anzeige auf dem Display gemäß einer Ausführungsform.
- Fig. 5a und 5b: Schematische Darstellung einer weiteren Ausführungsform des Maschinenschutzes.

### Ausführliche Beschreibung

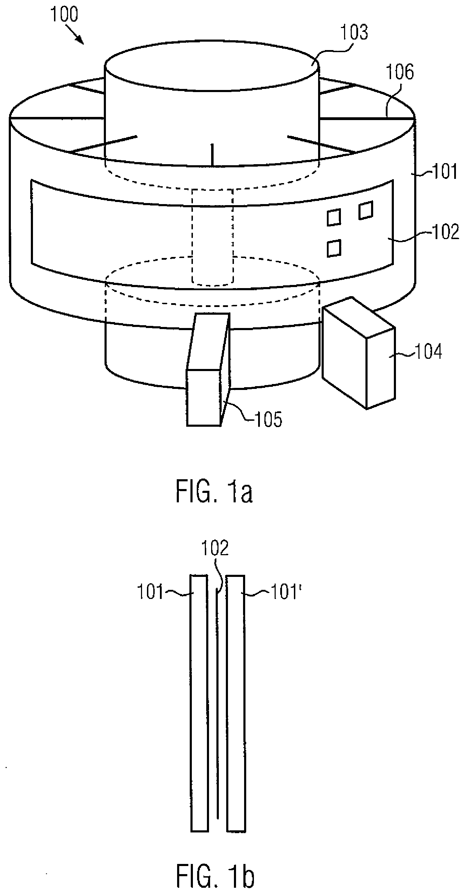

Fig. 1a zeigt eine schematische Darstellung einer erfindungsgemäßen Behälterbehandlungsmaschine 100. Diese umfasst üblicherweise einen Bereich 103, der für die Behandlung von Behältern genutzt wird. So kann es sich beispielsweise um eine Etikettier- oder Direktdruckmaschine handeln, wobei in diesem Bereich 103 die Behälter etikettiert oder bedruckt werden. Dazu können Behandlungsmodule 104 und 105 vorgesehen sein, wie beispielsweise Etikettieraggregate. Auch andere Ausführungsformen sind denkbar, beispielsweise kann es sich bei der Behälterbehandlungsmaschine 100 um eine allgemeine Ausstattungsmaschine für Behälter handeln oder um eine Blockmaschine, die aus vielen Einzelmaschinen zusammengesetzt sein kann.

Weiterhin umfasst die Behälterbehandlungsmaschine 100 einen Maschinenschutz 101, der beispielsweise über starre Verbindungen 106 mit dem behandelnden Teil der Behälterbehandlungsmaschine 103 verbunden sein kann. Dieser Maschinenschutz 101 kann sich dabei über die gesamte Peripherie oder einen Teil der Behälterbehandlungsmaschine 100 erstrecken. Das bedeutet, wenn diese beispielsweise als Rundläufermaschine ausgebildet ist, dass der Maschinenschutz vollumfänglich, beispielsweise wie hier dargestellt, in Form eines Zylindermantels vorgesehen ist. Es kann auch beabsichtigt sein, dass der Maschinenschutz nur in bestimmten Bereichen an der Peripherie der Behälterbehandlungsmaschine angeordnet ist, um ein versehentliches Eingreifen eines Benutzers, während die Behälterbehandlungsmaschine in Betrieb ist, zu verhindern. Weiterhin ist die hier dargestellte Form des Maschinenschutzes 101 so nicht zwingend. Der hier dargestellte Zylindermantel kann beispielsweise auch Einbuchtungen oder Ausbuchtungen umfassen, um zusätzliche Elemente, wie beispielsweise die Behandlungsmodule 104 und 105, aufnehmen zu können. Um dies noch weiter zu erleichtern, ist der Maschinenschutz 101 zumeist anhebbar und/oder wegschwenkbar ausgebildet.

Ferner umfasst der Maschinenschutz ein darauf angebrachtes Display 102. Dieses ist möglichst großflächig ausgebildet und nimmt wenigstens 10%, bevorzugt 20%, bevorzugt 50% oder mehr der Fläche des Maschinenschutzes 101 ein. Dieses Display ist in Form eines flexiblen Displays ausgebildet, wie beispielsweise ein OLED-Display. Da der Maschinenschutz 101 für gewöhnlich aus Plexiglas oder ähnlichen transparenten Materialien besteht, kann vorgesehen sein, dass das Display 102 zwischen zwei transparenten Platten angeordnet ist, um es gegen Umwelteinflüsse zu schützen.

Eine entsprechende Ausführungsform ist in Fig. 1b dargestellt. Das Display 102 ist hier zwischen den transparenten Platten 101 und 101' des Maschinenschutzes 101 aus Fig. 1 angeordnet. Dabei kann vorgesehen sein, dass die zusätzliche Platte 101' nur im Bereich des Maschinenschutzes 101 vorgesehen ist, in dem das Display 102 vorgesehen ist. So können Kosten bei der Fertigung eingespart werden.

Es sei darauf hingewiesen, dass der Maschinenschutz 101 nicht notwendigerweise transparent ist. In einem solchen Fall wäre die zusätzliche, das Display 102 abdeckende Platte 101' aus einem anderen Material, das in jedem Fall transparent sein muss, um die Sichtbarkeit der Anzeige des Displays 102 zu gewährleisten. So kann beispielsweise vorgesehen sein, dass diese zusätzliche Platte 101' unabhängig davon, ob der Maschinenschutz aus Plexiglas oder einem intransparenten Material besteht, aus kratzfestem Glas oder Kunststoff besteht. So kann das Display vor Verschmutzungen und Zerkratzen geschützt werden, was die Langlebigkeit erheblich erhöht.

Auf dem Display selbst können Informationen angezeigt werden, die für den Betrieb der Behälterbehandlungsmaschine 100 wichtig sein können. Im Allgemeinen handelt es sich dabei um Informationen den Betriebszustand der Behälterbehandlungsmaschine betreffend. Diese können, ohne darauf beschränkt zu sein, am Beispiel der Etikettiermaschine z.B. Drehzahlen für den Rundläufer, Etikettensorte, Anzahl der vorhandenen Etiketten, Ausschussmenge oder Ähnliches sein. Insbesondere kann das Display 102 genutzt werden, um im Fall von Umrüstarbeiten, wie beispielsweise einer Sortenumstellung, dem Bedienpersonal entsprechende Anleitungen und Informationen zur Verfügung zu stellen.

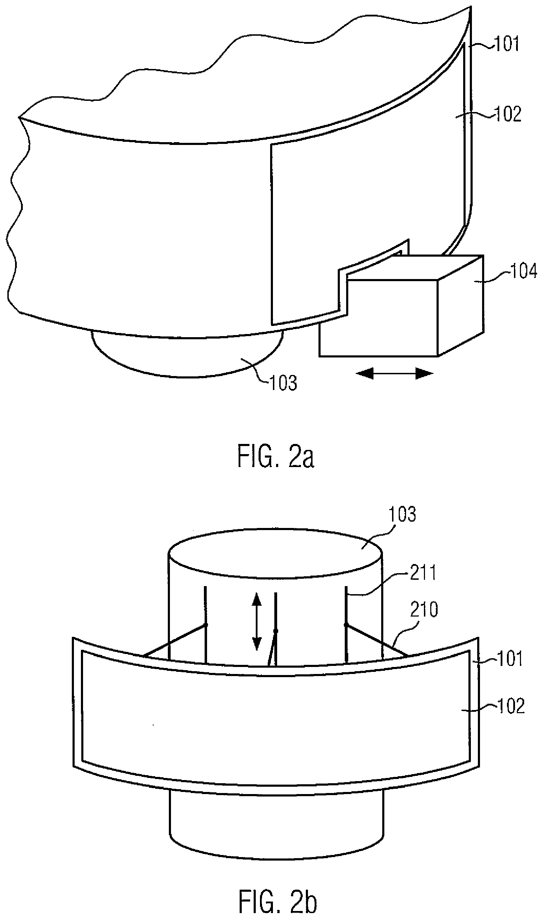

Zu diesem Zweck zeigt Fig. 2a eine Ausführungsform des Displays 102. Die Anordnung des Maschinenschutzes 101 gegenüber dem die Behälter behandelnden Teil 103 der Behälterbehandlungsmaschine ist hier analog zu der in Fig. 1 dargestellt. Das Display 102 erstreckt sich jedoch gezielt über einen Bereich, in dem ein Behandlungsmodul 104 angeordnet ist. In diesem Bereich kann das Display 102 so ausgelegt sein, dass es dem Bediener bestimmte Informationen über das Behandlungsmodul 104 zur Verfügung stellt. Weiterhin ist der Maschinenschutz und das Display so ausgebildet, dass das Behandlungsmodul 104 ohne zusätzliches Entfernen des Maschinenschutzes 101 und des Displays 102 ausgewechselt werden kann. Entsprechend fällt es dem Bedienpersonal leichter, das Behandlungsmodul 104 zu wechseln, da eine entsprechende Anleitung permanent über das Display 102 angezeigt werden kann, während das Behandlungsmodul 104 gewechselt wird. Ein solches Display kann auch weiteren Behandlungsmodulen zugeordnet sein oder an bestimmten Stellen der Behälterbehandlungsmaschine vorgesehen sein. So kann der Maschinenschutz 101 gegebenenfalls nicht nur ein Display 102 umfassen sondern eine Vielzahl. Entsprechende Displays könnten dann spezielle Aufgaben übernehmen wie die Anzeige von Informationen oder Anleitungen für ein bestimmtes Behandlungsmodul und/oder allgemeine Informationen über den Zustand der gesamten Behälterbehandlungsmaschine.

Weiterhin zeigt Fig. 2b eine Ausführungsform des Maschinenschutzes 101 mit beweglichen Verbindungen zur Behälterbehandlungsmaschine und insbesondere zu dem Behälter behandelnden Teil 103. Die Verbindungen umfassen dabei vorzugsweise Führungen 211 und darin eingelassene Verbindungselemente 210, die eine Verbindung zwischen dem Maschinenschutz 101 und den Führungen 211 eingehen. So wird beispielsweise eine Höhenverstellbarkeit des Maschinenschutzes 101 erreicht, was bei Umrüstungen oder Reparaturen insbesondere an dem die Behälter behandelnden Teil 103 der Behandlungsmaschine vorteilhaft sein kann, da so nicht der gesamte Maschinenschutz 101 mit Display 102 abgebaut werden muss, sondern dieser einfach in der Höhe verfahren werden kann, wodurch das Display weiterhin Informationen über die Behälterbehandlungsmaschine anzeigen kann. Hier ist es besonders vorteilhaft, wenn die Anzeige auf dem Display in Abhängigkeit der Position des Maschinenschutzes verändert wird. Wird beispielsweise der Maschinenschutz samt Display um eine Strecke h nach oben verfahren, kann die Anzeige auf dem Display in Richtung des unteren Rands des Displays um eine Strecke h verschoben werden, sodass sie für einen Bediener stets in der selben Höhe (beispielsweise auf Kopfhöhe) erscheint. Würde bei dieser Änderung der Darstellung ein Teil der anzuzeigenden Informationen unterhalb des unteren Displayrandes angezeigt werden müssen, kann die Anzeige weiterhin so verändert werden, dass die Informationen teilweise nebeneinander angezeigt werden, um eine Verschiebung von Informationen "aus dem Display hinaus" zu verhindern. Die Ausbildung der Verbindung zwischen Maschinenschutz und Behälterbehandlungsmaschine in der in Fig. 2b dargestellten Form ist nur eine mögliche Ausführungsform. Es kann auch vorgesehen sein, dass die Verbindungselemente 210 starr mit der Behälterbehandlungsmaschine, wie beispielsweise dem die Behälter behandelnden Teil 103 verbunden sind und die Führungen 211 in den Maschinenschutz eingelassen sind.

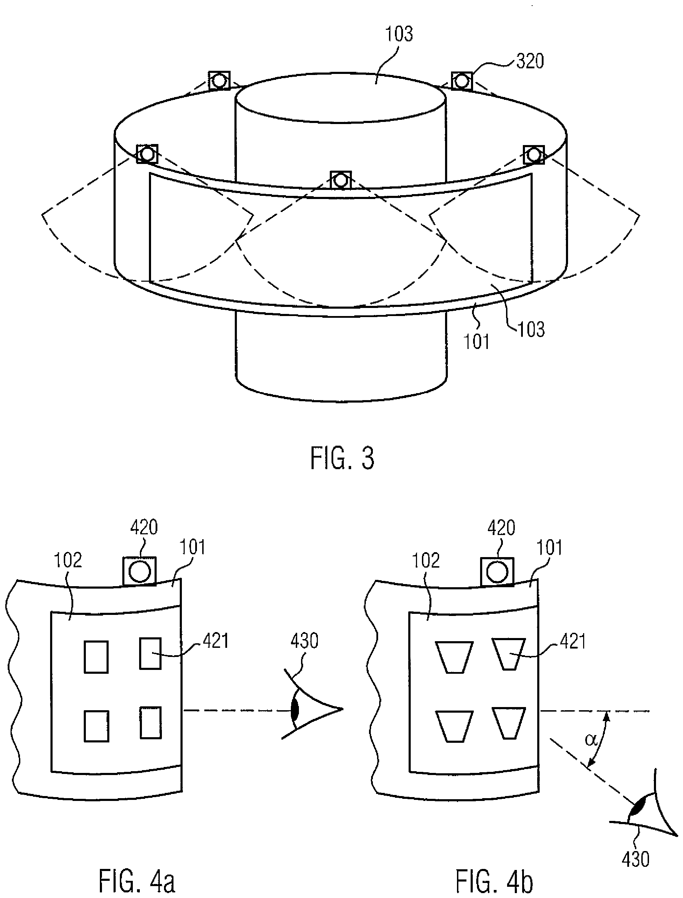

Fig. 3 zeigt die erfindungsgemäße Behälterbehandlungsmaschine, wobei mehrere Benutzererkennungseinheiten 320 am Maschinenschutz 102 befestigt sind. Vorzugsweise handelt es sich dabei um eine Vielzahl von Benutzererkennungseinheiten, die so angeordnet sind, dass eine Person, die sich in der Nähe des Maschinenschutzes 101 aufhält, (beispielsweise mit einem Abstand von weniger als 5 oder weniger als 3 oder weniger als 2 m) erkannt wird, egal wo sie in Relation zum Maschinenschutz steht. Das bedeutet für den Fall, dass der Maschinenschutz vollumfänglich um die Behälterbehandlungsmaschine vorgesehen ist, die Benutzererkennungseinheiten so verteilt sein müssen, dass sie eine Person am gesamten Umfang des Maschinenschutzes erkennen können. Diese Benutzererkennungseinheit ist geeignet, wenigstens die Position des Benutzers in unmittelbarer Umgebung der Behälterbehandlungsmaschine zu erkennen. Die so gewonnenen Daten werden dann an eine Steuereinheit weitergegeben. Diese Steuereinheit verändert in Abhängigkeit der Position des Benutzers dann die Anzeige auf dem Display. Ist beispielsweise vorgesehen, dass das Display permanent in einem bestimmten Bereich die aktuellen Betriebsparameter (Drehzahl, Ausschusshäufigkeit oder Ähnliches) anzeigt, ein Benutzer sich jedoch der Behälterbehandlungsmaschine so nähert, dass er diesen Teil des Displays nicht erkennen kann, kann die Steuereinheit gemäß den durch die Benutzererkennungseinheit übermittelten Daten die Anzeige auf dem Display so verändern, dass sie vom Benutzer erkannt werden kann. Darunter fallen beispielsweise Veränderungen der Position dieser speziellen Anzeige aber auch der Form und Schriftgröße.

Während die Benutzererkennungseinheit prinzipiell beliebig ausgebildet sein kann (beispielsweise kann es sich um handelsübliche Bewegungsmelder handeln), bietet die Ausbildung der Benutzererkennungseinheit mit Hilfe einer Kamera bzw. einer Vielzahl von Kameras 320 weitere Vorteile. Ist die bereits weiter oben beschriebene Steuereinheit geeignet, aufgenommene Bilddaten durch die Kamera zu verarbeiten und verfügt sie über ein Bilderkennungsmodul, mit dem eine Gesichtserkennung möglich ist, sind die Anwendungsmöglichkeiten des Displays 102 umfangreicher. So kann beispielsweise vorgesehen sein, dass die Steuereinheit über einen ihr zugeordneten Speicher verfügt, in dem Benutzerprofile hinterlegt sind, wobei diese Benutzerprofile, z.B. gewisse biometrische Daten zur Gesichtserkennung für eine Vielzahl von Nutzern speichern. Zusätzlich können für dessen Arbeit mit der Behälterbehandlungsmaschine relevante Daten in diesem Profil hinterlegt sein. So kann beispielsweise Mitarbeiter A aus dem englischsprachigen Raum stammen, während Mitarbeiter B aus China kommt. Da es grundsätzlich leichter fällt, Instruktionen in der Muttersprache zu verstehen, kann vorgesehen sein, dass die Steuereinheit nach erfolgreicher Erkennung des Gesichts eines bestimmten Mitarbeiters entscheidet, ob die Anzeige auf dem Display in einer anderen Sprache angezeigt werden soll. So kann die Steuereinheit die Anzeige des Displays auf englische Sprache umstellen, wenn Person A sich der Behälterbehandlungsmaschine nähert oder auf Chinesisch, wenn Mitarbeiter B sich der Behandlungsmaschine nähert. Auf diese Weise wird die Interaktion der Benutzer mit der Behälterbehandlungsmaschine erheblich erleichtert und Arbeiten können effektiver und möglichst fehlerfrei durchgeführt werden.

Durch die Gesichtserkennung ergibt sich auch ein weiterer Vorteil. So kann mittels der Gesichtserkennung und einer entsprechenden Bilderkennungssoftware die Blickrichtung des Benutzers in der Umgebung der Behälterbehandlungsmaschine erkannt werden.

Fig. 4 zeigt dazu zwei mögliche Blickwinkel, unter denen ein Benutzer 430 das Display 102 auf dem Maschinenschutz 101 betrachtet. Gemäß Fig. 4a ist die Blickrichtung des Benutzers 430 senkrecht zum Display 102. Üblich dargestellte geometrische Formen, wie hier beispielsweise Vierecke 421, können vom Benutzer 420 problemlos aus dieser Lage erkannt werden.

Gemäß Fig. 4b blickt der Bediener jedoch von schräg unten unter einem bestimmten Winkel auf das Display 102, so dass die Flächennormale des Displays und die Blickrichtung des Betrachters 430 einen Winkel α einschließen. Betrachtet eine Person beispielsweise Schrift oder geometrische Form auf einer ebenen Oberfläche senkrecht und unter einem bestimmten Winkel, fällt es erheblich schwerer, die entsprechenden Formen zu erkennen und klar zu identifizieren. Da dies aber gerade bei Umrüstarbeiten der Behälterbehandlungsmaschine notwendig sein kann, um bestimmte Bauteile eindeutig zu identifizieren, kann die Bilderkennungssoftware der Steuereinheit genutzt werden, die Anzeige auf dem Display 102 so zu verändern, dass die geometrischen Formen 421' so verändert werden, dass der Betrachter 430 aus seinem veränderten Blickwinkel wieder in der Lage ist, Strukturen wie in Fig. 4a zu erkennen. Dazu kann beispielsweise vorgesehen sein, dass die Anzeige auf dem Display 102 in Abhängigkeit von dem Blickwinkel, unter dem ein Benutzer das Display 102 betrachtet, verzerrt werden. Wird auf dem Display 102 beispielsweise ein Schriftbild angezeigt (eine Anleitung zum Umbau der Behandlungsmaschine), so können die Zeilen, die näher am Betrachter sind, in der üblichen Schriftgröße angezeigt werden, während weiter vom Betrachter entfernte Zeilen in einer größeren Schrift dargestellt werden.

Die Interaktion mit dem Display 102 muss sich nicht ausschließlich auf das Betrachten der auf diesem Display angezeigten Informationen beschränken. Es ist auch vorgesehen, dass die gesamte Steuerung der Behälterbehandlungsmaschine oder zumindest ein Teil davon, durch Bedienen des Displays 102 und damit über Interaktion mit der Steuereinheit erfolgen kann.

Erfindungsgemäß ist das Display 102 als Touch-Display ausgebildet sein. Es ist auch vorgesehen, dass nicht das gesamte Display 102 sondern nur Teile davon als Touch-Display ausgebildet sind oder dass ein mobiles Endgerät einem Benutzer zur Verfügung gestellt wird, mit dem er direkt auf die Steuereinheit zugreifen kann. Dieses mobile Endgerät kann beispielsweise in Form eines Tablet-Computers oder eines Labtops ausgebildet sein. Durch Bedienung des Touch-Displays und/oder des mobilen Endgeräts kann dann die Anzeige auf dem Display verändert werden und/oder die Behälterbehandlungsmaschine gezielt gesteuert werden.

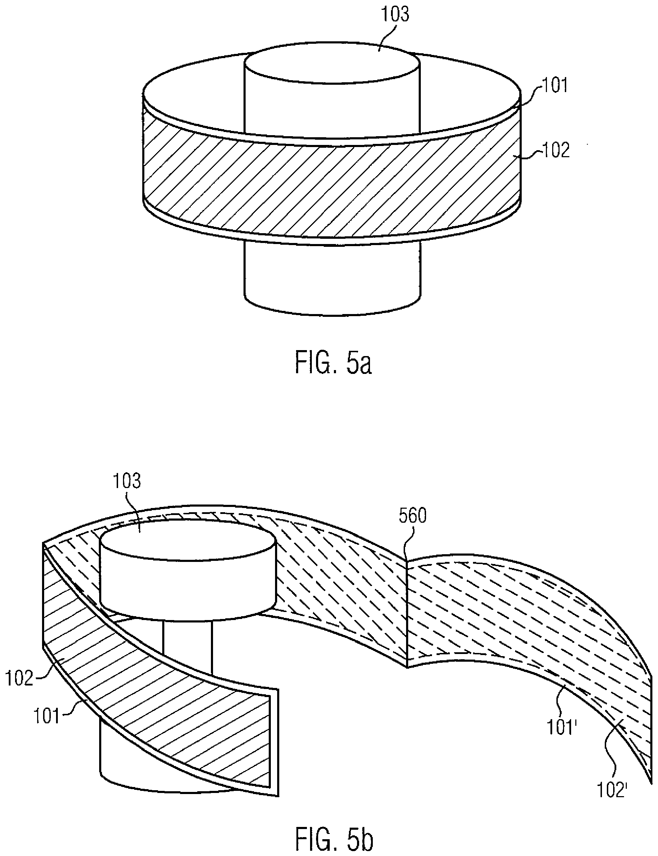

Fig. 5 zeigt eine weitere Ausführungsform der Behälterbehandlungsmaschine. Hier wird insbesondere der Vorteil der Verwendung flexibler Displays wie OLEDs deutlich. In Fig. 5a befindet sich der Maschinenschutz mit dem darauf angebrachten Display 102 in seinem Betriebszustand. Er schirmt das Innere der Behälterbehandlungsmaschine bzw. den die Behälter behandelnden Teil 103 von äußeren Einwirkungen, wie beispielsweise einem versehentlichen Hineingreifen eines Benutzers ab. Gleichzeitig wird die Gefahr von Verletzungen für Benutzer so verringert. Steht die Maschine jedoch still, um beispielsweise umgerüstet zu werden, kann es notwendig sein, auch in dem von dem Maschinenschutz 101 abgeschirmten Bereich Arbeiten vorzunehmen. Dazu kann vorgesehen sein, dass der Maschinenschutz 101, wie in Fig. 5b dargestellt, im Sinne einer Tür geöffnet werden kann. An der Tür 101' kann dann sogar vorteilhaft auf der Innenseite des Maschinenschutzes ein weiteres Display 102' vorgesehen sein, um hier nötige Anzeigen fortzusetzen und dem Benutzer direkt zugänglich zu machen. Durch die Verwendung flexibler Displays, wie OLED-Displays, kommt es beim Aufklappen der Tür an der Kante 560, um die die Tür 101' geschwenkt wird, jedoch nicht zu Beschädigungen des Displays, weshalb sich das Display auch über diesen Bereich problemlos erstrecken kann. Wird der Maschinenschutz 101 geöffnet, so kann über einen entsprechenden Schließmechanismus ein elektrisches Signal an die Steuereinheit gesendet werden, die dann automatisch auf das innenliegende Display 102' umschaltet und einem Benutzer dort wesentliche Informationen anzeigt.

## Patentansprüche

1. Behälterbehandlungsmaschine (100) zur Behandlung von Behältern wie beispielsweise Flaschen, mit einem Maschinenschutz (101), der zumindest im Betrieb aktive Teile der Behälterbehandlungsmaschine (100) gegen Eingriffe von außen, beispielsweise durch Bedienpersonal, abschirmt und sich zumindest teilweise über einen Teil der Peripherie der Behälterbehandlungsmaschine erstreckt, wobei in den Maschinenschutz (101) ein Display (102) integriert ist, auf dem Informationen z.B. über den Betriebszustand der Behälterbehandlungsmaschine (100) angezeigt werden können und wobei das Display (102) wenigstens teilweise als Touchdisplay ausgebildet ist, **dadurch gekennzeichnet, dass** eine Benutzererkennungseinheit (320) vorgesehen ist, die geeignet ist, die Position eines Benutzers in der Umgebung der Behälterbehandlungsmaschine (100) zu erkennen und dass eine Steuereinheit mit der Benutzererkennungseinheit (320) und dem Display (102) verbunden ist und die Anzeige auf dem Display (102) über die Steuereinheit Abhängigkeit von der Position eines Benutzers gesteuert wird.

2. Behälterbehandlungsmaschine (100) nach Anspruch 1, **dadurch gekennzeichnet, dass** das Display (102) ein flexibles Display, beispielsweise ein OLED-Display ist.

3. Behälterbehandlungsmaschine (100) nach Anspruch 1, **dadurch gekennzeichnet, dass** die Benutzererkennungseinheit (320) eine Kamera umfasst und die Steuereinheit über ein Bilderkennungsmodul verfügt.

4. Behälterbehandlungsmaschine (100) nach Anspruch 1 oder 3, **dadurch gekennzeichnet, dass** die Steuereinheit einen zugeordneten Speicher umfasst, in dem voreingestellte Anzeigeprofile gespeichert werden können und die Benutzererkennungseinheit (320) weiterhin geeignet ist, einen Benutzer in der Umgebung der Behälterbehandlungsmaschine (100) zu identifizieren und die Steuereinheit geeignet ist, eine Anzeige auf dem Display (102) in Abhängigkeit der Identifikation des Benutzers und gespeicherter Anzeigeprofile auszugeben.

5. Behälterbehandlungsmaschine (100) nach einem der Ansprüche 1 bis 4, **dadurch gekennzeichnet, dass** sich das Display (102) über einen Bereich des Maschinenschutzes (101) erstreckt, der zumindest teilweise ein Behandlungsmodul (104, 105) zur Behandlung von Behältern umfasst.

6. Behälterbehandlungsmaschine (100) nach einem der Ansprüche 1 bis 5, **dadurch gekennzeichnet, dass** der Maschinenschutz (101) zumindest teilweise aus Plexiglas besteht und/oder sich das Display (102) über mindestens 10%, vorzugsweise 20%, besonders bevorzugt 50% der Fläche des Maschinenschutzes (101) erstreckt.

7. Behälterbehandlungsmaschine (100) nach einem der Ansprüche 1 bis 6, **dadurch gekennzeichnet, dass** die Behälterbehandlungsmaschine (100) eine Ausstattungsmaschine für Behälter, beispielsweise eine Etikettiermaschine ist.

8. Behälterbehandlungsmaschine (100) nach einem der Ansprüche 1 bis 6, **dadurch gekennzeichnet, dass** die Behälterbehandlungsmaschine (100) eine aus mehreren Einzelmaschinen bestehende Blockmaschine ist.

9. Verfahren zum Anzeigen von Informationen, die beispielsweise den Betriebszustand einer Behälterbehandlungsmaschine (100) angeben, wobei die Informationen auf einem im Maschinenschutz (101) der Behälterbehandlungsmaschine (100) integrierten Display (102) angezeigt werden,
wobei die Anzeige auf dem Display (102) durch Interaktion eines Benutzers über das als Touchdisplay ausgebildete Display (102) verändert wird, **dadurch gekennzeichnet, dass**
mittels einer Benutzererkennungseinheit (320) ein Benutzer in der Umgebung der Behälterbehandlungsmaschine (100) erkannt wird und eine Anzeige auf dem Display (102) über eine Steuereinheit in Abhängigkeit von der Position des Benutzers gesteuert

10. Verfahren nach Anspruch 9, **dadurch gekennzeichnet, dass** die Benutzererkennungseinheit (320) den Benutzer identifiziert und die Anzeige auf dem Display (102) in Abhängigkeit von der Identifikation des Benutzers und in Abhängigkeit von in einem Speichern gespeicherten Profilen durch die Steuereinheit gesteuert wird.

11. Verfahren nach 9 oder 10, **dadurch gekennzeichnet, dass** die Steuereinheit die Position und/oder Darstellungsform der Anzeige auf dem Display (102) gemäß einer Veränderung der Position des Benutzers in Echtzeit ändert.

## Claims

1. A container handling machine (100) for handling containers, such as bottles for example, comprising a machine protection element (101) which shields active parts of the container handling machine (100) against interventions from the outside, for example by operating personnel, at least during operation and which extends at least partly over a part of the periphery of the container handling machine, wherein a display (102) is integrated into the machine protection element (101), wherein information, for example on the operating state of the container handling machine (100), can be displayed on the display, wherein the display is at least partially provided as a touch display, characiterized in that
a user recognition unit (320) is provided that is suitable to recognize the position of a user in the surroundings of the container handling machine (100), and that a control unit is connected to the user recognition unit (320) and the display (102) and the control unit controls the display on the display (102) depending on a user's position.

2. The container handling machine (100) according to claim 1, **characterized in that** the display (102) is a flexible display, for instance an OLED display.

3. The container handling machine (100) according to claim 1, **characterized in that** the user recognition unit (320) comprises a camera and the control unit includes an image recognition module.

4. The container handling machine (100) according to claim 1 or 3, **characterized in that** the control unit comprises an associated memory in which preset display profiles can be stored, and the user recognition unit (320) is further suitable to identify a user in the surroundings of the container handling machine (100) and the control unit is suitable to output a display on the display (102) depending on the identification of the user and stored display profiles.

5. The container handling machine (100) according to any one of claims 1 to 4, **characterized in that** the display (102) extends over a portion of the machine protection element (101) which at least partly comprises a handling module (104, 105) for handling containers.

6. The container handling machine (100) according to any one of claims 1 to 5, **characterized in that** the machine protection element (101) consists at least partly of plexiglass and/or the display (102) extends over at least 10%, preferably 20%, particularly preferably 50%, of the area of the machine protection element (101).

7. The container handling machine (100) according to any one of claims 1 to 6, **characterized in that** the container handling machine (100) is an outfitting machine for containers, for instance a labeling machine.

8. The container handling machine (100) according to any one of claims 1 to 6, **characterized in that** the container handling machine (100) is a block machine consisting of a plurality of individual machines.

9. A method for displaying information that for instance indicates the operating state of a container handling machine (100), wherein the information is displayed on an display (102) integrated in the machine protection element (101) of the container handling machine (100), wherein the display on the display (102) is changed by the control unit by interaction of a user via the display (102) designed as a touch display, **characterized in that** a user in the surroundings of the container handling machine (100) is recognized by means of a user recognition unit (320) and a display on the display (102) is controlled via a control unit depending on the user's position.

10. The method according to claim 9, **characterized in that** the user recognition unit (320) identifies the user, and the display on the display (102) is controlled by the control device depending on the identification of the user and depending on profiles stored in a memory.

11. The method according to claim 9 or 10, **characterized in that** the control unit changes in real time the position and/or form of representation of the display on the display (102) according to a change in the user's position.

## Revendications

1. Machine de traitement de récipients (100) pour le traitement de récipients tels que des bouteilles, avec un dispositif de protection de machine (101) qui protège, au moins pendant le fonctionnement, les parties actives de la machine de traitement de récipients (100) contre les interventions extérieures, par exemple du personnel de service, et qui s'étend au moins partiellement sur une partie de la périphérie de la machine de traitement de récipients, un affichage (102) sur lequel des informations, par exemple sur l'état de fonctionnement de la machine de traitement de récipients (100), peuvent être affichées, étant intégré dans le dispositif de protection de machine (101), **caractérisée en ce que** le dispositif de protection de machine (101) est pourvu d'un affichage (102) pour l'affichage d'informations sur l'état de fonctionnement de la machine de traitement de récipients (100).
et dans lequel l'affichage (102) est au moins partiellement conçu comme un affichage tactile, **caractérisé en ce qu'**une unité de reconnaissance de l'utilisateur (320) est prévue, qui est appropriée pour reconnaître la position d'un utilisateur à proximité de la machine de manutention de conteneurs (100) et **en ce qu'**une unité de commande est reliée à l'unité de reconnaissance de l'utilisateur (320) et à l'affichage (102) et l'affichage sur l'affichage (102) est commandé par l'intermédiaire de l'unité de commande en fonction de la position d'un utilisateur.

2. La machine de manutention de conteneurs (100) selon la revendication 1, **caractérisée en ce que** l'écran (102) est un écran flexible, par exemple un écran OLED.

3. Machine de manutention de conteneurs (100) selon la revendication 1, **caractérisée en ce que** l'unité de reconnaissance de l'utilisateur (320) comprend une caméra et l'unité de commande a un module de reconnaissance d'image.

4. Machine de manipulation de conteneurs (100) selon la revendication 1 ou 3, **caractérisée en ce que** l'unité de commande comprend une mémoire associée dans laquelle des profils d'affichage prédéfinis - peuvent être stockés et l'unité de reconnaissance d'utilisateur (320) est en outre adaptée pour identifier un utilisateur à proximité de la machine de manipulation de conteneurs (100) et l'unité de commande est adaptée pour sortir un affichage sur l'écran (102) en fonction de l'identification de l'utilisateur et des profils d'affichage stockés.

5. Machine de traitement de conteneurs (100) selon l'une des revendications 1 à 4, **caractérisée en ce que** l'affichage (102) s'étend sur une zone de la protection de la machine (101) qui comprend au moins partiellement un module de traitement (104, 105) pour le - traitement des conteneurs.

6. Machine de manipulation de conteneurs (100) selon l'une des revendications 1 à 5, **caractérisée en ce que** la protection de la machine (101) est au moins partiellement en plexiglas et/ou l'écran (102) s'étend sur au moins 10 %, de préférence 20 %, particulièrement de préférence 50 % de la surface de la protection de la machine (101).

7. Machine de traitement de conteneurs (100) selon l'une quelconque des revendications 1 à 6, **caractérisée en ce que** la machine de traitement de conteneurs (100) est une machine d'habillage pour conteneurs, par exemple une machine d'étiquetage.

8. Machine de manutention de conteneurs (100) selon l'une quelconque des revendications 1 à 6, **caractérisée en ce que** la machine de manutention de conteneurs (100) est une machine en bloc constituée de plusieurs machines individuelles.

9. Procédé d'affichage d'informations indiquant, par exemple, l'état de fonctionnement d'une machine de manutention de conteneurs (100), dans lequel les informations sont affichées sur un écran (102) intégré dans le protecteur de machine (101) de la machine de manutention de conteneurs (100),
dans lequel l'affichage sur l'écran (102) est modifié par l'interaction d'un utilisateur via l'écran (102) conçu comme un écran tactile, **caractérisé en ce que**
au moyen d'une unité de reconnaissance de l'utilisateur (320), un utilisateur est reconnu à proximité de la machine de manutention des conteneurs (100) et un affichage (102) est commandé par une unité de commande en fonction de la position de l'utilisateur.

10. Procédé selon la revendication 9, **caractérisé en ce que** l'unité de reconnaissance de l'utilisateur (320) identifie l'utilisateur et l'affichage sur l'écran (102) est commandé par l'unité de commande en fonction de l'identification de l'utilisateur et en fonction des profils enregistrés dans une mémoire.

11. Méthode selon 9 ou 10, **caractérisée en ce que** l'unité de commande modifie la position et/ou la forme de présentation de l'indication sur l'écran (102) en fonction d'un changement de la position de l'utilisateur en temps réel.
